# EUROPEAN PATENT APPLICATION

(11) **EP 4 621 426 A1**
(43) Date of publication of application: **24.09.2025**
(21) Application number: 24219083.3
(22) Date of filing: 11.12.2024
(51) Int. Cl.: G01R 31/367, G01R 31/3842, G01R 31/392

(54) **BATTERY STATUS CALCULATING SYSTEM AND ELECTRONIC DEVICE INCLUDING THE SAME**

(30) Priority: 18.03.2024 KR 20240037173
(71) Applicant: Samsung Electronics Co., Ltd., Suwon-si, Gyeonggi-do 16677 (KR)
(72) Inventor: PARK, Hyuk Rae, 16677 Suwon-si (KR); KWON, Min Kyu, 16677 Suwon-si (KR); KIM, Sang Beom, 16677 Suwon-si (KR); MOON, Sang Bin, 16677 Suwon-si (KR); SEO, Min Hwan, 16677 Suwon-si (KR); SEO, Jeong Hun, 16677 Suwon-si (KR); CHO, Sung Kyu, 16677 Suwon-si (KR)
(74) Representative: Marks & Clerk LLP

(57) **Abstract**

A battery status calculating system includes a first electronic device including a first sensor for sensing first information including voltage, current, and temperature of a first battery of a battery pack; and a first controller including a processor and a memory storing instructions, wherein the instructions are executed to cause the processor to receive second information including voltage, current, and temperature of a second battery of the battery pack, wherein the second battery is connected in parallel with the first battery, obtain a first State Of Charge (SOC) and a first State Of Health (SOH) of the first battery based on the first information by a battery-modeling, obtain a second SOC and a second SOH of the second battery based on the second information using the battery-modeling; and calculate a SOC of the battery pack based on the first SOC, the first SOH, the second SOC, and the second SOH.

## Description

### BACKGROUND

### 1. Technical Field

The present disclosure relates to a battery status calculating system and an electronic device including the same.

### 2. Discussion of Related Art

Accurately displaying a state of charge (SOC) of an electronic product that receives power through a secondary battery that can be charged and discharged (hereinafter referred to as 'battery') is a long-standing research purpose in the relevant technology field. In particular, in various electronic devices (e.g., a foldable smartphone, etc.) that use two or more batteries connected in parallel with each other, a user may want information about an integrated SOC rather than the SOCs of individual batteries. In this case, the integrated SOC refers to a SOC of all batteries connected in parallel with each and operated as a single battery, wherein the integrated SOC refers to the SOC of the single battery.

The SOC of the battery may indicate a remaining capacity relative to a total capacity (e.g., a maximum capacity) of the battery, typically expressed as a percentage. Various schemes may be used to calculate the SOC of the battery. For example, a current integration scheme using an equivalent circuit model (ECM) may be used to calculate the SOC of the battery. The current integration scheme may be inaccurate when there is an initial SOC error. In particular, as the battery ages, the error may increase, making it difficult to provide an accurate SOC value to the user.

Various battery-modeling schemes have been proposed to provide an accurate SOC of the battery. An electro-chemical thermal (ECT) modeling scheme is one example. In calculating the battery's SOC using the ECT modeling scheme, estimation accuracy of the SOC and SOH (State Of Health) may be calculated by modeling an aging trend of the battery in real time as the battery use time increases. In this scheme, a calculation process may be complicated, so that the scheme may use a relatively expensive calculation device and also have relatively high power consumption.

### SUMMARY

Aspects of the present disclosure provide a battery status calculating system with improved performance and reduced cost and/or power consumption.

Aspects of the present disclosure provide an electronic device with improved performance and reduced cost and/or power consumption.

However, aspects of the present disclosure are not limited to those set forth herein. The above and other aspects of the present disclosure that are not mentioned may be understood based on following descriptions, and may be more clearly understood based on embodiments according to the present disclosure. Further, it will be easily understood that aspects of the present disclosure may be realized using means illustrated in the claims and combinations thereof.

According to an aspect of present disclosure, a battery status calculating system comprises a first electronic device including a first sensor for sensing first information of a first battery included in a battery pack; and a first controller including a processor and a memory, wherein instructions defining an operation of the processor are stored in the memory, wherein the instructions are executed to cause the processor to receive second information of a second battery included in the battery pack, wherein the second battery is connected in parallel with the first battery, obtain a first State Of Charge (SOC) value and a first State Of Health (SOH) value of the first battery based on the first information using a first battery-modeling scheme, obtain a second SOC value and a second SOH value of the second battery based on the second information using the first battery-modeling scheme; and calculate a SOC of the battery pack based on the first SOC value, the first SOH value, the second SOC value, and the second SOH value.

According to other aspect of present disclosure, there is provided a battery status calculating system comprises a first electronic device including a first sensor for sensing first information including a voltage, a current, and a temperature of a first battery included in a battery pack, and a first controller configured to calculate a SOC (State Of Charge) of the first battery based on the first information by a first battery-modeling scheme, and a second electronic device including a second sensor for sensing second information including a voltage, a current, and a temperature of a second battery included in the battery pack and connected in parallel with the first battery, and a second controller configured to calculate a SOC of the second battery based on the second information by a second battery-modeling scheme different from the first battery-modeling scheme, wherein the second electronic device is configured to provide the second information to the first electronic device, wherein the first electronic device is configured to obtain a first SOC value by calculating the SOC of the first battery based on the first information by the first battery-modeling scheme, and obtain a second SOC value by calculating the SOC of the second battery based on the second information by the first battery-modeling scheme.

According to another aspect of present disclosure, there is provided an electronic device comprises a battery pack including a first battery and a second battery connected in parallel with each other, a host configured to receive power from the battery pack, a first electronic device configured to manage the first battery and sense first information including a voltage, a current, and a temperature of the first battery, and a second electronic device configured to manage the second battery and sense second information including a voltage, a current, and a temperature of the second battery, wherein the host is configured to provide a command to calculate a SOC (State Of Charge) of the battery pack to the first electronic device, wherein the second electronic device is configured to provide the second information to the first electronic device, wherein the first electronic device is configured to calculate the SOC of the battery pack based on the first information and the second information.

At least some of the above and other features of the disclosure are set out in the claims.

### BRIEF DESCRIPTION OF DRAWINGS

The above and other aspects and features of the present disclosure will become more apparent by describing in detail embodiments thereof with reference to the attached drawings, in which:
FIG. 1 is a block diagram showing a system including a battery status calculating system according to some embodiments.
FIG. 2 is a block diagram showing a first fuel gauge according to some embodiments.
FIG. 3 is a block diagram showing a second fuel gauge according to some embodiments.
FIG. 4 is a graph showing a SOC error percentage according to each battery-modeling scheme.
FIG. 5 is a block diagram showing an ADC circuit according to some embodiments.
FIG. 6a is a block diagram of a system implemented using a first fuel gauge and a second fuel gauge.
FIG. 6b is a block diagram of a system implemented using a first fuel gauge and an ADC circuit.
FIG. 7 is a flowchart for illustrating an operation of the battery status calculating system.
FIG. 8a is a block diagram of a system implemented using a first fuel gauge and a second fuel gauge.
FIG. 8b is a block diagram of a system implemented using a first fuel gauge, a second fuel gauge, and an ADC circuit.
FIG. 8c is a block diagram of a system implemented using a first fuel gauge and ADC circuits.
FIG. 9 is a block diagram of an electronic device to which a battery management system according to some embodiments is applied.
FIG. 10 is a foldable electronic device to which a battery status calculating system according to some embodiments is applied.

### DETAILED DESCRIPTION

Hereinafter, embodiments according to the technical idea of the present disclosure will be described with reference to the attached drawings.

The inventive concepts may be implemented in various modifications and have various forms, and specific embodiments are illustrated in the drawings and described in detail in the text. It is to be understood, however, that the inventive concepts are not intended to be limited to the particular forms disclosed, but on the contrary, is intended to cover all modifications, equivalents, and alternatives falling within the scope of the inventive concepts.

Like reference numerals or symbols refer to like elements throughout. In the drawings, the thickness, the ratio, and the dimension of an element may be exaggerated for effective description of the technical contents.

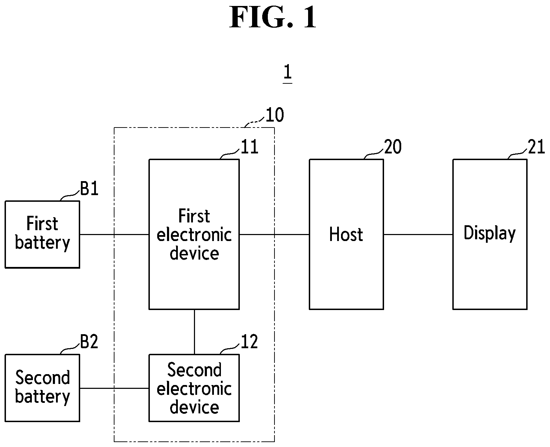

FIG. 1 is a block diagram showing a system including a battery status calculating system according to some embodiments.

Referring to FIG. 1, a system 1 including a battery status calculating system according to some embodiments may include a battery status calculating system 10, a first battery B1 and a second battery B2, a host 20, and a display 21. Embodiments of the present disclosure are not limited thereto, and the system 1 may further include other components in addition to the components as shown. The first battery B1 and the second battery B2 may supply power to the system 1, the components as shown, and other components not shown. Although two batteries are shown in FIG. 1, the number of the batteries is not limited to two and at least two batteries may be included in the system 1. The first and second batteries B1 and B2 may have a same capacity as each other or may have different capacities, respectively. The first battery B1 and the second battery B2 may be connected in parallel with each other. In this regard, hereinafter, all batteries, including the first battery B1 and the second battery B2, of the system 1 that may supply power to the system 1 and other components included in the system 1 may be collectively referred to as 'battery pack'.

The battery status calculating system 10 may include a first electronic device 11 and a second electronic device 12. The first electronic device 11 may be connected to the first battery B1 and may manage the first battery B1. The second electronic device 12 may be connected to the second battery B2 and may manage the second battery B2.

The host 20 may control various components included in the system 1. For example, the host 20 may transmit, to the first electronic device 11, a request for information about the integrated SOC of all batteries connected to the system 1, including the first battery B1 and the second battery B2. The request for information may be a request for information about the state of charge (SOC) of the battery pack. Additionally, the host 20 may provide the first electronic device 11 with charge/discharge cycle information of each of the batteries connected to the system 1. The charge/discharge cycle information may be information about a number of times a certain battery has been charged and discharged over its service life. Additionally, the host 20 may display information about the integrated SOC provided from the first electronic device 11 through the display 21.

In addition, the display 21 may display the information about the integrated SOC under control of the host 20. The display 21 may display the information about the integrated SOC that a user may visually perceive.

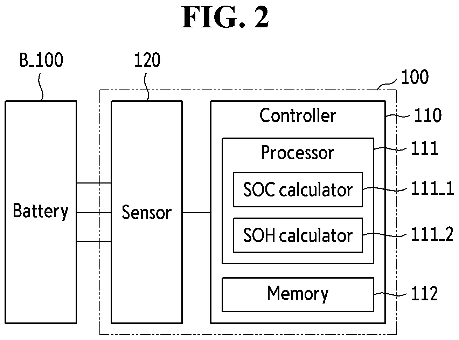

FIG. 2 is a block diagram showing a first fuel gauge according to some embodiments.

Referring to FIG. 2, a first fuel gauge 100 may include a first controller 110 and a first sensor 120. The first fuel gauge 100 may be a battery fuel gauge. In addition, although not shown, the first fuel gauge 100 may further include an analog-to-digital converter and a current limiter. The analog-to-digital converter and/or the current limiter may be included inside the first fuel gauge 100 or may be disposed outside the first fuel gauge 100.

The first controller 110 may be a computing device such as an MCU (Micro Controller Unit). The first controller 110 may include a first processor 111 and a first memory 112. In addition, although not shown, the first controller 110 may further include a communication device such as an SPI (Serial Peripheral Interface) or an I2C (Inter-Integrated Circuit), a I/O interface, and a timer. Embodiments of the present disclosure are not limited thereto, and the first controller 110 may be implemented with various configurations.

The first memory 112 may be used as a main memory device of the first processor 111 and may store therein at least one of firmware, programs, or instructions. The firmware, programs, or instructions may define various operations and calculations that the first processor 111 may perform. The first processor 111 may control an operation of the first fuel gauge 100 or perform one or more calculations according to the firmware, the programs, and/or the instructions stored in the first memory 112. For example, the first processor 111 may control a first sensor 120 so that the first sensor 120 senses first information of a first target battery B_100. The first information may include a voltage, a current, and a temperature of the first target battery B_100. Furthermore, the first processor 111 may calculate the SOC and SOH (state of health) of the first target battery B_100 based on the voltage, current, and temperature of the first battery B1 obtained through the first sensor 120 or the SOC and SOH (state of health) of another battery whose voltage, current, and temperature information has been received by the first processor 111. For example, the first processor 111 may include a first SOC calculator 111_1 and a SOH calculator 111_2. In this regard, the first processor 111 may calculate the SOC and SOH of one or more batteries through various battery-modeling schemes according to the firmware, programs, and/or instructions stored in the first memory 112. A description of the SOC and SOH calculation will be provided herein. In addition, the first processor 111 may update one or more deterioration parameters of the first target battery B_100 or another battery based on respective voltage, current, and temperature information. The first processor 111 may update the deterioration parameter of the first target battery B_100 or another battery in real time based on the respective voltage, current, and temperature information. A description of the updating of the deterioration parameters will be set forth later.

The first sensor 120 may sense first information including the voltage, current, and temperature of the first target battery B_100 under the control of the first controller 110. The analog-to-digital converter (not shown) may convert the first information into digital data and provide the digital data to the first controller 110. For example, the first controller 110 may perform an analog-to-digital function on the first information. The current limiter (not shown) may protect the first target battery B_100 and components connected thereto by limiting flow of instantaneous high current due to cell unbalancing between a plurality of batteries connected in parallel with each other.

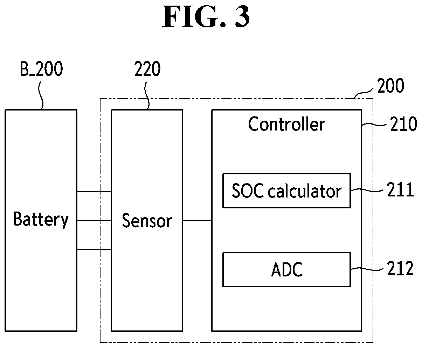

FIG. 3 is a block diagram showing a second fuel gauge according to some embodiments.

Referring to FIG. 3, a second fuel gauge 200 may include a second controller 210 and a second sensor 220.

The second controller 210 may be implemented using a hardware logic chip such as a Field Programmable Gate Array (FPGA) and an Application Specific Integrated Circuit (ASIC). Embodiments of the present disclosure are not limited thereto, and the second controller 210 may be implemented with various configurations. The second controller 210 may include a second SOC calculator 211 and a first analog-to-digital converter 212. The second SOC calculator 211 may sense second information of a second target battery B_200. The second information may include a voltage, a current, and a temperature of the second target battery B_200. The second SOC calculator 211 may calculate the SOC of a second target battery B_200 based on the second information of the second target battery B_200 obtained through the second sensor 220. For example, the second SOC calculator 211 may calculate a local SOC of the second target battery B_200 based on the second information of the second target battery B_200. The first analog-to-digital converter 212 may convert the second information into digital data and provide the digital data to the second controller 210. For example, the first analog-to-digital converter 212 may perform an analog-to-digital function on the second information. Although not shown, the second controller 210 may further include a current limiter. The current limiter (not shown) may protect the second target battery B_200 and components connected thereto by limiting flow of instantaneous high current due to cell unbalancing between a plurality of batteries connected in parallel with each other. In this regard, the current limiter (not shown) and the first analog-to-digital converter 212 may be disposed inside the controller such that the current limiter (not shown), the first analog-to-digital converter 212, and the second SOC calculator 211 may be integrated into a single chip. Alternatively, the current limiter (not shown) and/or the first analog-to-digital converter 212 may be disposed inside or outside the second fuel gauge 200. The second sensor 220 may sense the voltage, current, and temperature of the second target battery B_200 under the control of the second controller 210.

In this regard, the second controller 210 may provide, to the first electronic device 11 (see FIG. 1), the second information about the second target battery B_200 as obtained by sensing the voltage, current, and temperature of the second target battery B_200 using the second sensor. The second controller 210 may not provide the local SOC of the second target battery B_200 to the first electronic device 11 (see FIG. 1).

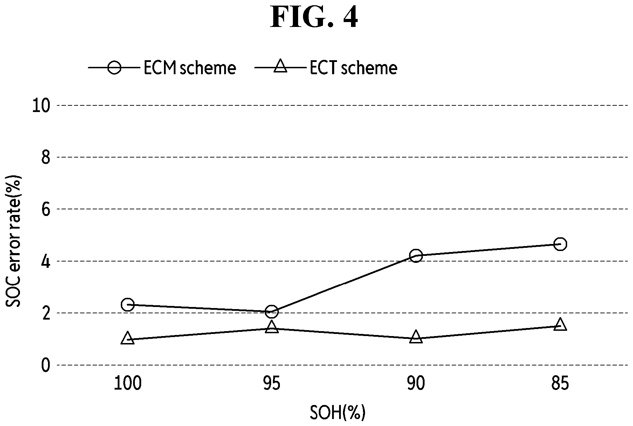

FIG. 4 is a graph showing a SOC error percentage according to different battery-modeling schemes.

The graph in FIG. 4 shows the target battery's SOC error rate based on change in the SOH of a target battery in each of the battery-modeling schemes, that is, the ECT scheme and the ECM scheme. The target battery's SOC error rate may be the error rate due to a difference between the actual SOC of the battery and the calculated SOC thereof. The Y-axis represents the SOC error rate of the target battery in %, and the X-axis represents the SOH of the target battery in %. The SOH indicates a current performance of the target battery relative to an initial performance thereof, and starts at about 100% and may gradually decrease as a deterioration of the target battery progresses.

Referring to FIGS. 1 to 4, the first fuel gauge 100 and the second fuel gauge 200 may calculate the SOCs of the first target battery B_1 00 and the second target battery B_200 connected thereto using different battery-modeling schemes, respectively. For example, the first fuel gauge 100 may calculate the SOC of the first target battery B_100 in a first battery-modeling scheme, and the second fuel gauge 200 may calculate the SOC of the second target battery B_200 in a second battery-modeling scheme.

Each of the first battery-modeling scheme and the second battery-modeling scheme may be configured for estimating and calculating various states of the battery with non-linear characteristics, and may be embodied as various battery-modeling schemes. In this regard, the first battery-modeling scheme may calculate the SOC of the target battery more accurately than the second battery modeling scheme. In order to accurately calculate the SOC of the target battery, the SOC of the target battery may be calculated in consideration of various parameters (hereinafter referred to as `deterioration parameters') based on an actual deterioration of the target battery. Accordingly, in a case where the first battery-modeling scheme may calculate the SOC of the target battery more accurately than the second battery modeling scheme, a more complicated calculation may be needed to calculate the SOC of the target battery. That is, the first fuel gauge 100 may use a relatively complicated calculation, and therefore may be relatively expensive and consume a larger amount of power compared to the second fuel gauge 200.

For example, the first battery-modeling scheme may be an electro-chemical thermal modeling (ECT) scheme. The second battery-modeling scheme may be an equivalent circuit modeling (ECM) scheme. The ECT scheme may refer to a scheme of modeling the characteristics of the target battery based on a chemical reaction that occurs inside the target battery, and the ECM scheme may refer to a scheme of modeling the characteristics of the target battery using an equivalent circuit. Since it is well known how to model a battery and calculate the SOC in each of the ECT scheme and the ECM scheme, a description thereof may be omitted.

The ECM scheme may have the advantage that calculation is relatively simpler than that in the ECT scheme. Thus, in the ECM scheme, a relatively inexpensive calculator may be used. However, the ECM scheme may have a disadvantage in that the accuracy of the SOC calculation may be lower than that of the ECT scheme. In particular, as the target battery deteriorates, the accuracy of SOC calculation may gradually decrease in the ECM scheme. For example, referring to the graph in FIG. 4, when the SOH of the target battery progresses from about 100% to about 85%, the SOC error percentage tends to increase from about 2% to about 4% using the ECM scheme. However, in the ECT scheme, the SOC error percentage exhibits a substantially constant trend as the target battery ages.

According to some embodiments, in the first fuel gauge 100, the first processor 111 may calculate the SOC using one or more of firmware, program, or instructions stored in the first memory 112. However, the second fuel gauge 200 may calculate the SOC according to a designed circuit configuration of the second controller 210 implemented using the hardware logic chip as included in the second fuel gauge 200. In other words, the first fuel gauge 100 may change the battery-modeling scheme or modify the SOC calculating algorithm according to an adopted battery-modeling scheme by modifying one or more of the firmware, programs, or instructions stored in the first memory 112. However, the second fuel gauge 200 may not modify the SOC calculating algorithm.

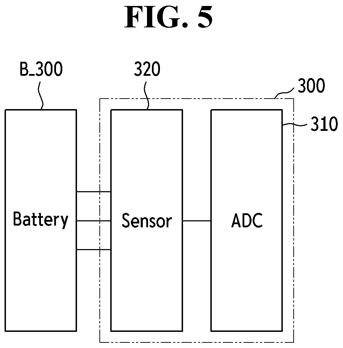

FIG. 5 is a block diagram showing an ADC circuit according to some embodiments.

Referring to FIG. 5, an ADC circuit 300 may not include a SOC calculator, and may include a second analog-to-digital converter 310 and a third sensor 320.

The second analog-to-digital converter 310 may convert voltage, current, and temperature information (e.g., third information) about a third target battery B_300 obtained through the third sensor 320 into digital data and may transmit the digital data to the first electronic device 11 (see FIG. 1). Although not shown, the ADC circuit 300 may further include a current limiter. A current limiter (not shown) may protect the third target battery B_300 and connected components thereto by limiting flow of instantaneous high current due to cell unbalancing between a plurality of batteries connected in parallel with each other. In this regard, the current limiter (not shown) may be disposed inside the ADC circuit 300 such that the current limiter (not shown) and the second analog-to-digital converter 310 may be integrated into a single chip. Alternatively, the current limiter (not shown) may be disposed outside the ADC circuit 300.

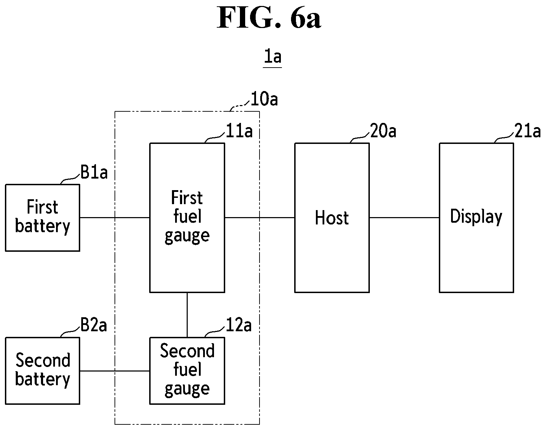

FIG. 6a is a block diagram of a system implemented using a first fuel gauge and a second fuel gauge.

Referring to FIG. 1 and FIG. 6a, a system 1a may include a battery status management system 10a including the first fuel gauge 100 (see FIG. 2) and the second fuel gauge 200 (see FIG. 3). The first electronic device 11 may be implemented using a first fuel gauge 11a. The second electronic device 12 may be implemented using a second fuel gauge 12a. A host 20a may transmit a request for the SOC value of the battery pack to the first fuel gauge 11a. The second fuel gauge 12a may send the voltage, current, and temperature information about a second battery B2a to the first fuel gauge 11a. The first fuel gauge 11a may calculate the SOC of the battery pack based on the voltage, current, and temperature information about each of the first battery B1a and the second battery B2a. The first fuel gauge 11a may provide the SOC value of the battery pack to the host 20a. The host 20a may display the SOC value of the battery pack through the display 21a so that the user may visually perceive the SOC value.

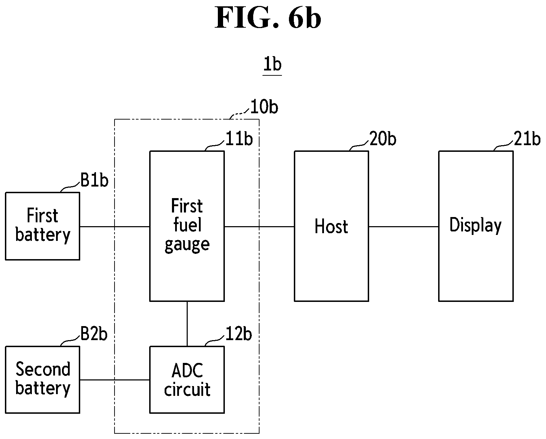

FIG. 6b is a block diagram of a system implemented using a first fuel gauge and an ADC circuit.

Referring to FIG. 1 and FIG. 6b, a system 1b may include a battery status management system 10b including the first fuel gauge 100 (see FIG. 2) and the ADC circuit 300 (see FIG. 5). The first electronic device 11 may be implemented using a first fuel gauge 11b. The second electronic device 12 may be implemented using an ADC circuit 12b. A host 20b may transmit a request for the SOC value of the battery pack to the first fuel gauge 1 1b. The ADC circuit 12b may send the voltage, current, and temperature information about a second battery B2b to the first fuel gauge 11b. The first fuel gauge 11b may calculate the SOC of the battery pack based on the voltage, current, and temperature information about each of the first battery B1b and the second battery B2b. For example, the first fuel gauge 1 1b may calculate the SOC of the battery pack based on the first information about the first battery B1b and the second information about the second battery B2b. The first fuel gauge 1 1b may provide the SOC value of the battery pack to the host 20b. The host 20b may display the SOC value of the battery pack through the display 21b so that the user may visually perceive the SOC value.

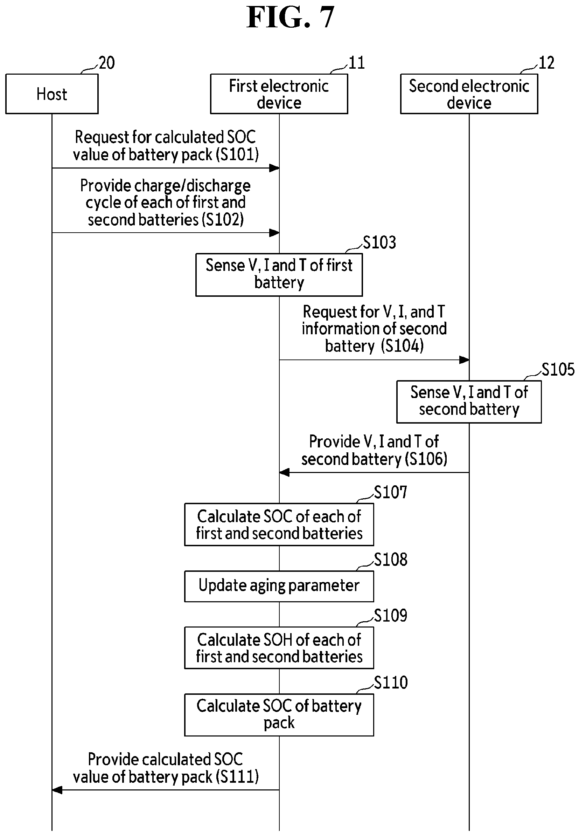

FIG. 7 is a flowchart for illustrating an operation of the battery status calculating system.

Referring to FIG. 1 and FIG. 7, the host 20 may first transmit a request for the SOC value of the battery pack to the first electronic device 11 in S101. For example, the host 20 may control the first electronic device 11 to provide the SOC value of the battery pack to the host 20, or may issue a command to the first electronic device 11 to provide the SOC value of the battery pack to the host 20. In addition, the host 20 may provide the first electronic device 11 with data necessary to calculate the SOC of the battery pack, such as information about the charge/discharge cycle of the battery pack in S102. The first electronic device 11 may sense the first battery B1 using the sensor to obtain first information including voltage V, current I, and temperature T information about the first battery.

The first electronic device 11 may transmit a request for second information including voltage, current, and temperature information about the second battery B2 to the second electronic device 12 in S104. For example, the first electronic device 11 may control the second electronic device 12 so that the second electronic device 12 provides the second information to the first electronic device 11, or may issue a command to the second electronic device 12 to provide the second information thereto. The second electronic device 12 may acquire the second information by sensing the second battery B2 using the sensor in S105. The second electronic device 12 may convert the second information into digital data in the analog-to-digital manner and provide the digital data to the first electronic device 11 in S106. In this regard, the second electronic device 12 may not calculate the SOC of the second battery B2. Alternatively, even though the second electronic device 12 calculates a local SOC of the second battery B2, the second electronic device 12 may not provide the local SOC value of the second battery B2 to the first electronic device 11 and/or the host 20. However, embodiments of the present disclosure are not limited thereto. By not providing the local SOC value of the second battery B2 to the first electronic device 11, unnecessary communications and therefore power consumption may be reduced. Additionally, the first electronic device 11 may calculate the SOC of the second battery B2. The SOC calculated by the first electronic device 11 may be more accurate than SOC calculated by the second electronic device 12.

The first electronic device 11 may calculate the SOC of the first battery B1 and the SOC the second battery B2 based on each of the first information and the second information in S107. The first electronic device 11 may obtain the first SOC value by calculating the SOC of the first battery B1 based on the first information. The first electronic device 11 may obtain the second SOC value by calculating the SOC of the second battery B2 based on the second information.

Furthermore, the first electronic device 11 may update the deterioration parameters of the first battery B1 based on the first information, and information about the charge/discharge cycles of the first battery B1 received from the host 20. The deterioration parameters may include various parameters related to the deterioration of the target battery, which may be used in modeling the target battery in the ECT scheme. Since the deterioration parameters used in the ECT modeling scheme are well known, descriptions thereof may be omitted. The first electronic device 11 may obtain the first SOH value by calculating the SOH of the first battery B1 based on the updated deterioration parameters of the first battery B1 in S109. Likewise, the first electronic device 11 may update the deterioration parameters of the second battery B2 based on the second information, and information about the charge/discharge cycle of the second battery B2 received from the host 20 in S108. The first electronic device 11 may calculate the SOH of the second battery based on the updated deterioration parameters of the second battery B2 to obtain the second SOH value in S109.

The first electronic device 11 may calculate the SOC of the battery pack based on the first SOC value, the second SOC value, the first SOH value, and the second SOH value obtained as the result of the calculating process in S 110. The first electronic device 11 may provide the calculated SOC value of the battery pack to the host 20 in S111.

The process in which the host 20 requests the SOC value of the battery pack of the first electronic device 11, and the first electronic device 11 calculates the SOC of the battery pack and provides the calculated SOC to the host 20 may occur on a preset interval, or may occur repeatedly under an external command.

Referring to FIGS. 1 to 5, the first electronic device 11 may be implemented using the first fuel gauge 100 as described herein. The second electronic device 12 may be implemented using the second fuel gauge 200 or the ADC circuit as described herein. According to some embodiments, as described herein, the first electronic device 11 may receive the voltage, current, and temperature information from the second electronic device 12 and may calculate the SOC of each of the first battery B1 and the second battery B2. Compared to a case of using the local SOC value calculated by the second electronic device 12, the SOC of the battery pack may be calculated more accurately. Furthermore, the SOC of each of the batteries may be calculated in a corresponding battery-modeling scheme. Compared to the case of using the local SOC value calculated by the second electronic device 12, the calculation error may be reduced against using two or more battery-modeling schemes. In a case where a calculation error may be reduced, a battery management system operation may achieve improved results, for example, by extending battery life or improving battery performance.

The first fuel gauge 100 may calculate the SOC of the target battery more accurately than the second fuel gauge 200. As described herein, the first fuel gauge 100 may be relatively expensive and consume a relatively large amount of power. According to some embodiments, in a system including two or more batteries connected in parallel to each other, the battery status calculation system may be provided that may have reduced cost and reduced power consumption, compared to a case where the first fuel gauges 100 are connected to the batteries, respectively.

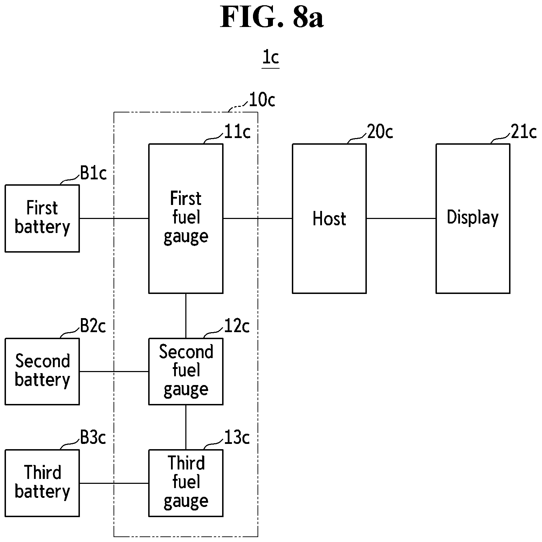

FIG. 8a is a block diagram of a system implemented using a first fuel gauge and a second fuel gauge.

Referring to FIG. 1 and FIG. 8a, a system 1c may further include a third battery B3c connected in parallel with a first battery B1c and a second battery B2c, and a third fuel gauge 13c that may manage the third battery B3c. A first fuel gauge 11c may be implemented using the first fuel gauge 100 (see FIG. 2) as described herein. Each of a second fuel gauge 12c and a third fuel gauge 13c may be implemented using the second fuel gauge 200 (see FIG. 3) as described herein. A host 20c may transmit a request for the SOC value of the battery pack to the first fuel gauge 11c. The second fuel gauge 12c and the third fuel gauge 13c may provide second information and third information including respective voltages, currents, and temperatures information about the second battery B2c and the third battery B3c to the first fuel gauge 11c, respectively. The first fuel gauge 11c may calculate the SOC of the battery pack based on the first to third information. The first fuel gauge 11c may provide the SOC value of the battery pack to the host 20c. The host 20c may display the SOC value of the battery pack through a display 21c so that the user may visually recognize the SOC value.

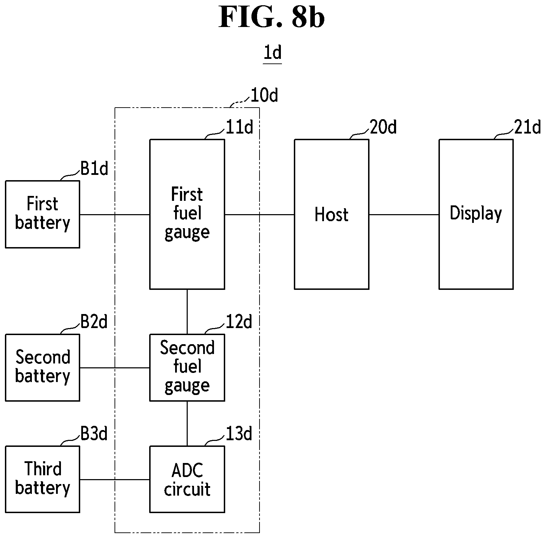

FIG. 8b is a block diagram of a system implemented using a first fuel gauge, a second fuel gauge, and an ADC circuit.

Referring to FIG. 1 and FIG. 8b, a first fuel gauge 11d may be implemented using the first fuel gauge 100 (see FIG. 2) as described herein. A second fuel gauge 12d may be implemented using the second fuel gauge 200 (see FIG. 3). An ADC circuit 13d may be implemented using the ADC circuit 300 (see FIG. 5). A host 20d may transmit a request for the SOC value of the battery pack to the first fuel gauge 11d. The second fuel gauge 12d and the ADC circuit 13d may provide second information and third information including respective voltages, currents, and temperatures information about a second battery B2d and a third battery B3d to the first fuel gauge 11d, respectively. The first fuel gauge 11d may calculate the SOC of the battery pack based on the first to third information. The first fuel gauge 11d may provide the SOC value of the battery pack to the host 20d. The host 20d may display the SOC value of the battery pack through a display 21d so that the user may visually recognize the SOC value.

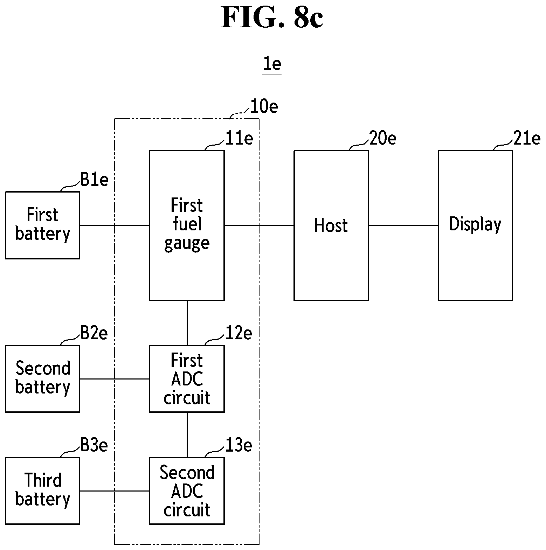

FIG. 8c is a block diagram of a system implemented using a first fuel gauge and ADC circuits.

Referring to FIG. 1 and FIG. 8c, a first fuel gauge 11e may be implemented using the first fuel gauge 100 (see FIG. 2) as described herein. Each of a first ADC circuit 12e and a second ADC circuit 13e may be implemented using the ADC circuit 300 (see FIG. 5). A host 20e may transmit a request for the SOC value of the battery pack to the first fuel gauge 11e. The first ADC circuit 12e and the second ADC circuit 13e may provide second information and third information including respective voltages, currents, and temperatures information about a second battery B2e and a third battery B3e to the first fuel gauge 11e, respectively. The first fuel gauge 11e may calculate the SOC of the battery pack based on the first to third information. The first fuel gauge 11e may provide the SOC value of the battery pack to the host 20e. The host 20e may display the SOC value of the battery pack through a display 21e so that the user may visually recognize the SOC value.

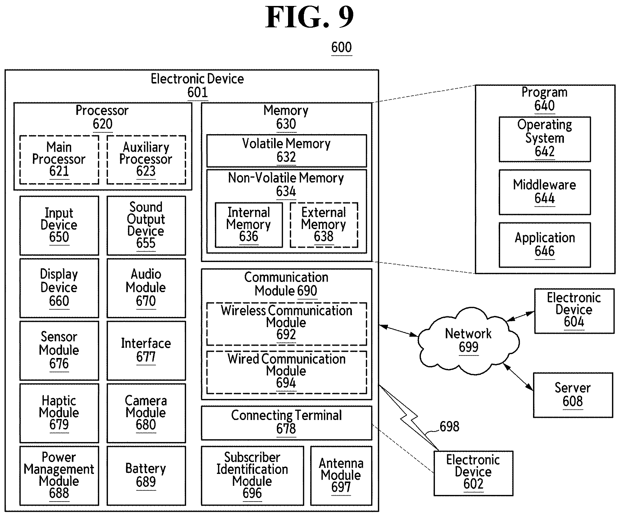

FIG. 9 is a block diagram of an electronic device to which a battery management system according to some embodiments is applied.

Referring to FIG. 9, an electronic device 601 in a network environment 600 may communicate with an electronic device 602 over a first network 698, such as a short-range wireless communication network, or may communicate with an electronic device 604 or a server 608 over a second network 699 such as a long-range wireless communication network. The electronic device 604 and/or the server 608 may be an external device. In some embodiments, the electronic device 601 may be, for example, a notebook computer, a laptop computer, or a portable mobile terminal. However, embodiments of the present disclosure are not limited thereto.

The electronic device 601 may communicate with the electronic device 604 through the server 608. The electronic device 601 may include a processor 620, a memory 630, an input device 650, an audio output device 655, a display device 660, an audio module 670, a sensor module 676, an interface 677, a haptic module 679, a camera module 680, a power management module 688, a battery 689, a communication module 690, a subscriber identification module (SIM) 696, or an antenna module 697.

In some embodiments, at least one of the components such as the display device 660 or the camera module 680 may be omitted from the electronic device 601, or one or more other components may be added to the electronic device.

In some embodiments, some of the components may be implemented into a single integrated circuit (IC). For example, the sensor module 676 such as a fingerprint sensor, an iris sensor, and an illuminance sensor may be embedded in the image display device such as a display.

The processor 620 may execute software (e.g., program 640) that controls other components of at least one electronic device 601 such as hardware or software components connected to the processor 620 to perform various data processing and operations.

According to some embodiments, the system 1 (see FIG. 1) may be embodied as an electronic device 601, and the host 20 (see FIG. 1) may be embodied as the processor 620.

In at least some of data processing or operations, the processor 620 may load commands or data received from other components such as, for example, the sensor module 676 or the communication module 690 into the volatile memory 632 and may process the commands or data stored in the volatile memory 632, and may store resulting data in the non-volatile memory 634.

The processor 620 may include a main processor 621, for example, a central processing unit (CPU) or an application processor (AP), an auxiliary processor 623 that operates independently of the main processor 621 or operates in conjunction with the main processor 621.

This auxiliary processor 623 may include, for example, a graphics processing unit (GPU), an image signal processor (ISP), a sensor hub processor, or a communication processor (CP). Embodiments of the present disclosure are not limited thereto, and the auxiliary processor 623 may be implemented with various configurations.

In some embodiments, the auxiliary processor 623 may consume less power than the main processor 621 may consume or be configured to perform a specific function. The auxiliary processor 623 may be separated from the main processor 621 or may be embodied as a portion thereof.

The auxiliary processor 623 may control at least some of the functions or states related to at least one component among the components of the electronic device 601 on behalf of the main processor 621 while the main processor 621 is inactive, or in conjunction with the main processor 621 while the main processor 621 is active.

The memory 630 may store therein various data used in at least one component of the electronic device 601. This variety of data may include, for example, software such as the program 640 and input data and output data for command related thereto. The memory 630 may include the volatile memory 632 and the non-volatile memory 634.

The program 640 may be stored as the software in the memory 630 and may include, for example, an operating system (OS) 642, middleware 644, or an application 646.

The input device 650 may receive commands or data to be used in other components of the electronic device 601 from an external source to the electronic device 601. The input device 650 may include, for example, a microphone, a mouse, or a keyboard. The audio output device 655 may output an audio signal to an external device to the electronic device 601. This audio output device 655 may include, for example, a speaker. Multimedia data may be output through the speaker.

The display device 660 may visually provide information to an outside out of the electronic device 601. The image display device may include, for example, a display, a hologram device, or a projector, and a control circuit that controls corresponding one of the display, the hologram device, or the projector.

In some embodiments, the display device 660 may include touch circuitry configured to detect a touch, or sensor circuitry, such as, for example, a pressure sensor, configured to measure an intensity of a force caused by the touch.

According to some embodiments, the display 21 (see FIG. 1) may be embodied as the display device 660.

The audio module 670 may convert sound into an electrical signal or vice versa. In some embodiments, the audio module 670 may obtain the sound through the input device 650, or may output the sound through the audio output device 655, or through a headphone of an electronic device 602 connected directly or wirelessly to the electronic device. For example, the electronic device 602 may be an external electronic device.

The sensor module 676 may detect an operating state of the electronic device 601, such as an output or a temperature, or an environmental state external to the electronic device 601, such as the user's state, and may generate an electrical signal or a data value corresponding to the detected state. The sensor module 676 may include, for example, a gesture sensor, a gyro sensor, an atmospheric pressure sensor, a magnetic sensor, an acceleration sensor, a grip sensor, a proximity sensor, a color sensor, an infrared sensor, an infrared (IR) sensor, a biometric sensor, a temperature sensor, a humidity sensor, or an illuminance sensor.

The interface 677 may support one or more specified protocols to be used by the electronic device 601 connected directly or wirelessly to the electronic device 602. In some embodiments, the interface 677 may include, for example, a high definition multimedia interface (HDMI), a universal serial bus (USB) interface, a secure digital (SD) card interface, or a voice interface.

The connection terminal 678 may include a connector through which the electronic device 601 may be physically connected to the electronic device 602. In some embodiments, the connection terminal 678 may include, for example, an HDMI connector, a USB connector, an SD card connector, or a voice connector (e.g., a headphone connector).

The haptic module 679 may convert an electrical signal into a mechanical stimulus, such as vibration or movement that can be perceived by the user through tactile sensation or kinesthetic sensation. In some embodiments, the haptic module 679 may include, for example, a motor, a piezoelectric element, or an electrical stimulator.

The camera module 680 may capture still images or moving images. In some embodiments, the camera module 680 may include one or more lenses, an image sensor, an image signal processor, or a flash.

The battery 689 may supply power to at least one component of electronic device 601. According to one embodiment, the battery 689 may include, for example, a non-rechargeable primary battery, a rechargeable secondary battery, or a fuel cell.

According to some embodiments, the battery 689 may be comprised of a plurality of batteries connected in parallel with each other. The battery 689 may be embodied as the battery pack as described herein.

The power management module 688 may manage the power supplied to the electronic device 601. The power management module may be embodied, for example, as at least a portion of a power management integrated circuit (PMIC).

According to some embodiments, the battery status calculating system 10 in FIG. 1 may be embodied as at least a portion of the power management module 688. The power management module 688 may be connected to a plurality of batteries included in the battery 689 and may calculate the SOC of the battery 689 under the control of the processor 620. When the processor 620 requests the SOC value of the battery 689 of the power management module 688, the power management module 688 may sense the voltage, current, and temperature of each of the plurality of batteries included in the battery 689 to obtain respective information about the voltage, current, and temperature of the plurality of batteries, and may calculate the SOC and SOH of each of the plurality of batteries included in the battery 689 based on the obtained voltages, currents, and temperatures. The power management module 688 may calculate the SOC of the battery 689 based on the calculated SOC value and SOH value. The power management module 688 may provide the calculated SOC value of the battery 689 to the processor 620.

The communication module 690 may support establishment of a direct communication channel and/or a wireless communication channel between the electronic device 601 and an external electronic device, such as, for example, the electronic device 602, the electronic device 606, or the server 608, and may perform communication over the established communication channel.

The communication module 690 may include one or more communication processors that may operate independently of the processor 620 and may support direct communication and/or wireless communication.

In some embodiments, the communication module 690 may include a wireless communication module 692, such as, for example, a cellular communication module, a short-range wireless communication module, or a global navigation satellite system (GNSS) communication module, or a wired communication module 694 such as a local area network (LAN) communication module or a power line communication (PLC) module.

A corresponding communication module among these communication modules may communicate with an external electronic device through a first network 698, such as for example, BLUETOOTH^{®}, wireless-fidelity (Wi-Fi) direct, or standard of Infrared Data Association (IrDA), or a second network 699, such as a mobile communication network, the Internet, or a long-distance communication network.

These various types of communication modules may, for example, be embodied into a single component or as a plurality of separate components. The wireless communication module 692 may identify and authenticate the electronic device 601 in a communication network such as the first network 698 or the second network 699 using subscriber information, such as, for example, international mobile subscriber identity (IMSI) stored in the subscriber identification module 696.

The antenna module 697 may transmit or receive signals or power to or from the electronic device 601. In some embodiments, the antenna module 697 may include one or more antennas. At least one antenna appropriate for a communication scheme used within the communication network, such as the first network 698 or the second network 699, may be selected therefrom by the communication module 690. Then, a signal or power may be transmitted or received between the communication module and the external electronic device through the selected at least one antenna.

At least some of the aforementioned components may be interconnected to each other, and may communicate the signal therebetween through an inter-peripheral communication scheme such as, for example, a bus, general purpose input and output GPIO, serial peripheral interface (SPI), or mobile industry processor interface (MIPI).

In some embodiments, the commands or data may be transmitted or received between the electronic device 601 and the electronic device 606 through the server 608 connected to the second network 699. Each of the electronic device 602 and electronic device 606 may be of the same type or a different type from a type of the electronic device 601. All or some of the operations to be performed on the electronic device 601 may be executed on one or more external electronic devices. For example, all or some of the operations to be performed on the electronic device 601 may be performed on one or more of the electronic device 602, electronic device 606, or server 608.

For example, when the electronic device 601 is to perform a function or service automatically or in response to a request from a user or another device, the electronic device 601 executing the function or service may request one or more external electronic devices to perform at least a portion of the function or service. Upon receiving the request, the one or more external electronic devices may perform at least a portion of the requested function or service, or an additional function or service, related to the request and may transmit a result to the electronic device 601. The electronic device 601 may provide the result as at least a portion of the response to the request, with or without additional processing of the result. For this purpose, for example, cloud computing, distributed computing, or client-server computing schemes may be used.

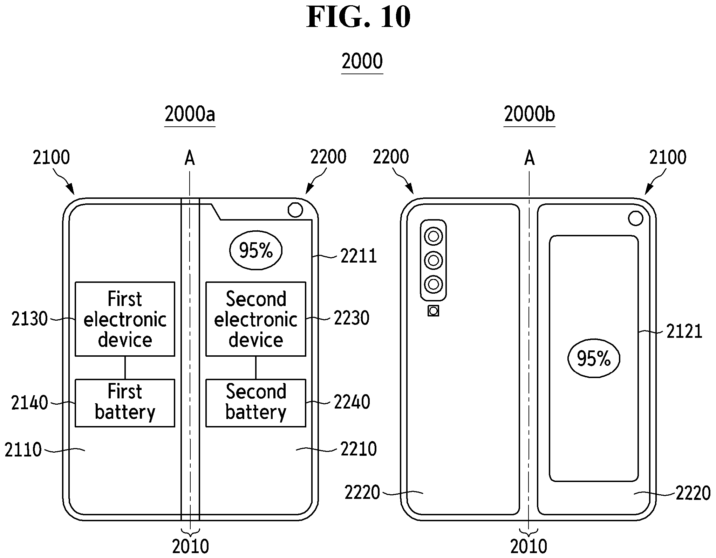

FIG. 10 is a foldable electronic device to which a battery status calculating system according to some embodiments may be applied.

Referring to FIG. 10, a foldable electronic device 2000 may correspond to the electronic device 601 (see FIG. 9) as described herein. The foldable electronic device 2000 may include a first housing 2100 including a first surface 2110 and a third surface 2120, and a second housing 2200 including a second surface 2210 and a fourth surface 2220. The first surface 2110 of the first housing 2100 and the second surface 2210 of the second housing 2200 may form a front surface 2000a of the foldable electronic device 2000. The third surface 2120 and the fourth surface 2220 of the second housing 2200 may form a rear surface 2000b of the foldable electronic device 2000. The first housing 2100 and the second housing 2200 may be disposed at sides around a folding axis (e.g., A-axis) and may have a substantially symmetrical shape with respect to each other around the folding axis. The first housing 2100 and the second housing 2200 may be designed to be foldable relative to each other. A hinge structure 2010 may be formed between the first housing 2100 and the second housing 2200, so that the front surface 2000a of the foldable electronic device 2000 may be foldable.

The foldable electronic device 2000 may have a first display 2211 at the first surface 2110 and the second surface 2210 that may form the front surface 2000a of the electronic device. The first display 2211 may be formed entirely across the front surface 2000a. The first display 2211 may refer to a flexible display including at least a partial area that may be deformed to be flat or curved. The first display 2211 may be foldable in a left or right direction around the folding axis. Furthermore, the foldable electronic device 2000 may have a second display 2121 at a portion of the rear surface 2000b of the electronic device. The second display 2121 may be formed across at least a portion of the third surface 2120 of the foldable electronic device 2000.

The first housing 2100 may include a first battery 2140, and the second housing 2200 may include a second battery 2240. The capacities of the first battery 2140 and the second battery 2240 may be the same as each other or different from each other. The first housing 2100 may receive therein a first electronic device 2130 that may be connected to the first battery 2140 and may manage the first battery 2140. The second housing 2200 may receive therein a second electronic device 2230 that may be connected to the second battery 2240 and may manage the second battery 2240.

According to some embodiments, the first electronic device 11 (see FIG. 1) and the first battery B1 (see FIG. 1) as described herein may correspond to the first electronic device 2130 and the first battery 2140 of the foldable electronic device 2000, respectively. The second electronic device 12 (see FIG. 1) and the second battery B2 (see FIG. 1) as described herein may correspond to the second electronic device 2230 and the second battery 2240 of the foldable electronic device 2000, respectively. Each of the first display 2211 and the second display 2121 of the foldable electronic device 2000 may display the SOC value of the battery pack including the first battery 2140 and the second battery 2240 under the control of the processor 620 (see FIG. 9) so that the user may visually perceive the SOC value.

Although embodiments of the present disclosure have been described with reference to the accompanying drawings, the present disclosure is not limited to example embodiments, but may be implemented in various different forms. A person skilled in the art may appreciate that the present disclosure may be practiced in other concrete forms without changing the technical scope or essential characteristics of the present disclosure. Therefore, it should be appreciated that embodiments as described herein are not restrictive but illustrative in all respects.

## Claims

1. A battery status calculating system comprising:
a first electronic device including:
a first sensor for sensing first information of a first battery included in a battery pack; and
a first controller including a processor and a memory, wherein instructions defining an operation of the processor are stored in the memory,
wherein the instructions are executed to cause the processor to:
receive second information of a second battery included in the battery pack, wherein the second battery is connected in parallel with the first battery;
obtain a first State Of Charge (SOC) value and a first State Of Health (SOH) value of the first battery based on the first information using a first battery-modeling scheme;
obtain a second SOC value and a second SOH value of the second battery based on the second information using the first battery-modeling scheme; and
calculate a SOC of the battery pack based on the first SOC value, the first SOH value, the second SOC value, and the second SOH value.

2. The battery status calculating system of claim 1, wherein the first battery-modeling scheme includes an electro-chemical thermal (ECT) modeling scheme, and
the first sensor senses the first information including a voltage, a current, and a temperature of the first battery.

3. The battery status calculating system of claim 1 or 2, further comprising a second electronic device,
wherein the second electronic device includes:
a second sensor for sensing the second information including a voltage, a current, and a temperature of the second battery; and
an analog-to-digital converter configured to convert the second information into digital data and to provide the digital data to the first electronic device.

4. The battery status calculating system of claim 1 or 2, further comprising a second electronic device,
wherein the second electronic device includes:
a second sensor for sensing the second information including a voltage, a current, and a temperature of the second battery; and
a second controller configured to calculate the SOC of the second battery using a second battery-modeling scheme different from the first battery-modeling scheme.

5. The battery status calculating system of claim 4, wherein the second controller is configured to calculate the SOC of the second battery to obtain a local SOC value.

6. The battery status calculating system of claim 5, wherein the second battery-modeling scheme includes an equivalent circuit modeling (ECM) scheme.

7. The battery status calculating system of claim 1 or 2, further comprising a second electronic device,
wherein the second electronic device includes at least one logic chip, and is configured to calculate the SOC of the second battery using the at least one logic chip.

8. The battery status calculating system of claim 7, wherein the second electronic device is configured to calculate the SOC of the second battery by a second battery-modeling scheme different from the first battery-modeling scheme.

9. The battery status calculating system of claim 8, wherein the second battery-modeling scheme includes an equivalent circuit modeling (ECM) scheme.

10. The battery status calculating system of any preceding claim, wherein the instructions are executed to cause the processor to update a first deterioration parameter of the first battery and to update a second deterioration parameter the second battery, based on each of the first information and the second information by the first battery-modeling scheme.

11. A battery status calculating system comprising:
a first electronic device including:
a first sensor for sensing first information including a voltage, a current, and a temperature of a first battery included in a battery pack; and
a first controller configured to calculate a State of Charge (SOC) of the first battery based on the first information by a first battery-modeling scheme; and
a second electronic device including:
a second sensor for sensing second information including a voltage, a current, and a temperature of a second battery included in the battery pack and connected in parallel with the first battery; and
a second controller configured to calculate a SOC of the second battery based on the second information by a second battery-modeling scheme different from the first battery-modeling scheme,
wherein the second electronic device is configured to provide the second information to the first electronic device,
wherein the first electronic device is configured to:
obtain a first SOC value by calculating the SOC of the first battery based on the first information by the first battery-modeling scheme; and
obtain a second SOC value by calculating the SOC of the second battery based on the second information by the first battery-modeling scheme.

12. The battery status calculating system of claim 11, wherein the first electronic device is configured to update a deterioration parameter of each of the first battery and the second battery, based on each of the first information and the second information by the first battery-modeling scheme.

13. The battery status calculating system of claim 12, wherein the first electronic device is configured to:
obtain a first SOH (State Of Health) value by calculating a SOH of the first battery based on the deterioration parameter of the first battery,
obtain a second SOH value by calculating a SOH of the second battery based on the deterioration parameter of the second battery.

14. The battery status calculating system of claim 13, wherein the first electronic device is configured to calculate a SOC of the battery pack based on the first SOC value, the first SOH value, the second SOC value, and the second SOH value.

15. An electronic device comprising:
a battery pack including a first battery and a second battery connected in parallel with each other;
a host configured to receive power from the battery pack;
a first electronic device configured to manage the first battery and sense first information including a voltage, a current, and a temperature of the first battery; and
a second electronic device configured to manage the second battery and sense second information including a voltage, a current, and a temperature of the second battery,
wherein the host is configured to provide a command to calculate a SOC (State Of Charge) of the battery pack to the first electronic device,
wherein the second electronic device is configured to provide the second information to the first electronic device,
wherein the first electronic device is configured to
calculate the SOC of the battery pack using on the first information and the second information.
